# EUROPEAN PATENT APPLICATION

(11) **EP 4 507 013 A1**
(43) Date of publication of application: **12.02.2025**
(21) Application number: 23779930.9
(22) Date of filing: 22.03.2023
(51) Int. Cl.: H01L 31/12, H03K 17/78

(54) **SEMICONDUCTOR RELAY AND SEMICONDUCTOR RELAY MODULE PROVIDED WITH SAME**

(30) Priority: 01.04.2022 JP 2022061746
(71) Applicant: Panasonic Intellectual Property Management Co., Ltd., Osaka-shi, Osaka 540-6207 (JP)
(72) Inventor: KURIAKI, Tomonari, Kadoma-shi, Osaka 571-0057 (JP); KITAHARA, Daisuke, Kadoma-shi, Osaka 571-0057 (JP); TSUNEOKA, Michiaki, Kadoma-shi, Osaka 571-0057 (JP); KAJIMOTO, Yoshiyuki, Kadoma-shi, Osaka 571-0057 (JP)
(74) Representative: Grünecker Patent- und Rechtsanwälte PartG mbB
(86) International application number: PCT/JP2023/011155
(87) International publication number: WO 2023/189918

(57) **Abstract**

A semiconductor relay 1 is provided with at least a housing 11, a first input terminal 6, a second input terminal 7, a first output terminal 8, a second output terminal 9, a light-emitting element 2, a light receiving element 51, a first MOSFET 3, and a second MOSFET 4. The light-emitting element 2 is disposed to a first main surface 7d1 of a first substrate 7d, and a light-receiving drive element 5 is disposed to a second main surface 10a of a second substrate 10. A source electrode 5a of the light-receiving drive element 5 and the second substrate 10 are connected to the same potential. The second substrate 10 is disposed between the first MOSFET 3 and the second MOSFET 4 when viewed along the first axis. The normal of the first main surface 7d1 of the first substrate 7d intersects the normal of the second main surface 10a of the second substrate 10.

## Description

### TECHNICAL FIELD

The present disclosure relates to a semiconductor relay and a semiconductor relay module including the semiconductor relay.

### BACKGROUND ART

Conventionally, a semiconductor relay also called a MOSFET output photocoupler or an optical MOSFET has been known as an AC signal transmission unit.

In the conventional semiconductor relay, depending on arrangement of an input terminal, an output terminal, and a conductive member connected thereto, a stub, i.e., a signal branch, is formed, which leads to a problem that an insertion loss increases in the vicinity of a resonance frequency due to resonance at the stub and an available frequency band is narrowed.

In order to solve this problem, for example, Patent Document 1 proposes a configuration in which conductor frames on which MOSFETs are mounted are arranged on both sides of a conductor frame on which a light receiving element is mounted. With this frame arrangement, the length of the stub can be shortened, and narrowing of the available frequency band due to the influence of the stub can be prevented.

### CITATION LIST

### PATENT DOCUMENT

PATENT DOCUMENT 1: Japanese Patent Application No. 2011-082916

### SUMMARY OF THE INVENTION

### TECHNICAL PROBLEM

However, in the conventional configuration disclosed in Patent Document 1, capacitive coupling and inductive coupling occur due to a structure between signal input and output, and in a case where a high frequency signal is transmitted to the output side, the signal may leak to the input side through such coupling.

Moreover, in the conventional configuration, the physical length of an input terminal connected to a light emitting element for signal input is long, and accordingly, an input-side electrical length is long. Note that the electrical length is a length with reference to an electromagnetic wave propagation speed in a signal transmission medium, and the physical length and the electrical length are the same as each other in vacuum, but the electrical length is longer than the physical length in a general transmission medium.

When the input-side electrical length is long, a resonance phenomenon occurs in a semiconductor relay accordingly, which may degrade output-side high frequency characteristics.

The present disclosure has been made in view of the above-described points, and an object thereof is to provide a semiconductor relay capable of reducing degradation of an output signal due to an input-side structure and a semiconductor relay module including the semiconductor relay.

### SOLUTION TO THE PROBLEM

In order to accomplish the above-described object, the semiconductor relay according to the present disclosure includes at least a housing having an upper surface and a lower surface located below the upper surface in a first axis, a first input terminal and a second input terminal, a first output terminal and a second output terminal, a light emitting element electrically connected to the first input terminal and the second input terminal, a light receiving drive element having a first surface receiving light output from the light emitting element, a second surface located below the first surface in the first axis, and a first electrode, a first MOSFET having a first intermediate electrode electrically connected to the first electrode, a first output electrode electrically connected to the first output terminal, and a first gate electrode, a second MOSFET having a second intermediate electrode electrically connected to the first electrode, a second output electrode electrically connected to the second output terminal, and a second gate electrode, a first base having a first principal surface on which the light emitting element is disposed, and a connection conductor having a second principal surface on which the light receiving drive element is disposed and connected to the first electrode with a potential equal to that of the first electrode. At least part of the connection conductor is disposed between the first MOSFET and the second MOSFET as viewed along the first axis, and the normal to the first principal surface crosses the normal to the second principal surface.

The semiconductor relay module according to the present disclosure includes at least the above-described semiconductor relay and a circuit board on which first to fourth lines are formed. The first line and the second line are each connected to the first input terminal and the second input terminal of the semiconductor relay, and the third line and the fourth line are each connected to the first output terminal and the second output terminal of the semiconductor relay.

### ADVANTAGES OF THE INVENTION

According to the present disclosure, capacitive coupling and inductive coupling between an input and an output can be reduced, and an input-side electrical length can be shortened. Thus, output-side high frequency characteristics can be improved.

### BRIEF DESCRIPTION OF THE DRAWINGS

[FIG. 1] FIG. 1 is a perspective view of a semiconductor relay according to a first embodiment.
[FIG. 2] FIG. 2 is a view of the semiconductor relay along a second axis.
[FIG. 3] FIG. 3 is a perspective view of a first input terminal and a second input terminal on which a light emitting element is mounted.
[FIG. 4] FIG. 4 is a view of a light receiving drive element, a first MOSFET, and a second MOSFET along a first axis.
[FIG. 5] FIG. 5 is an equivalent circuit diagram of the semiconductor relay.
[FIG. 6] FIG. 6 is a perspective view of the semiconductor relay.
[FIG. 7] FIG. 7 is a perspective view of a semiconductor relay according to a comparative example.
[FIG. 8] FIG. 8 is one example of the frequency dependency of an insertion loss in an output-side transmission signal of the semiconductor relay.
[FIG. 9] FIG. 9 is a perspective view of a semiconductor relay according to a first modification.
[FIG. 10] FIG. 10 is a view of a semiconductor relay according to a second modification along the first axis.
[FIG. 11] FIG. 11 is a view of a light receiving drive element, a first MOSFET, and a second MOSFET according to a third modification along the first axis.
[FIG. 12] FIG. 12 is a perspective view of a semiconductor relay according to a second embodiment.
[FIG. 13] FIG. 13 is a schematic graph for describing a difference in a resonance phenomenon before and after insertion of a resistor into an input side.
[FIG. 14] FIG. 14 is a perspective view of a semiconductor relay module according to a third embodiment.
[FIG. 15] FIG. 15 is a view of the semiconductor relay module along the second axis.
[FIG. 16] FIG. 16 is a view of the semiconductor relay module along a third axis.

### DESCRIPTION OF EMBODIMENTS

Hereinafter, embodiments of the present disclosure will be described with reference to the drawings. Note that description of the preferred embodiments below is merely an example in nature and is not intended to limit the scope, application, and use of the present disclosure.

### (First Embodiment)

### [1: Configuration of Semiconductor Relay]

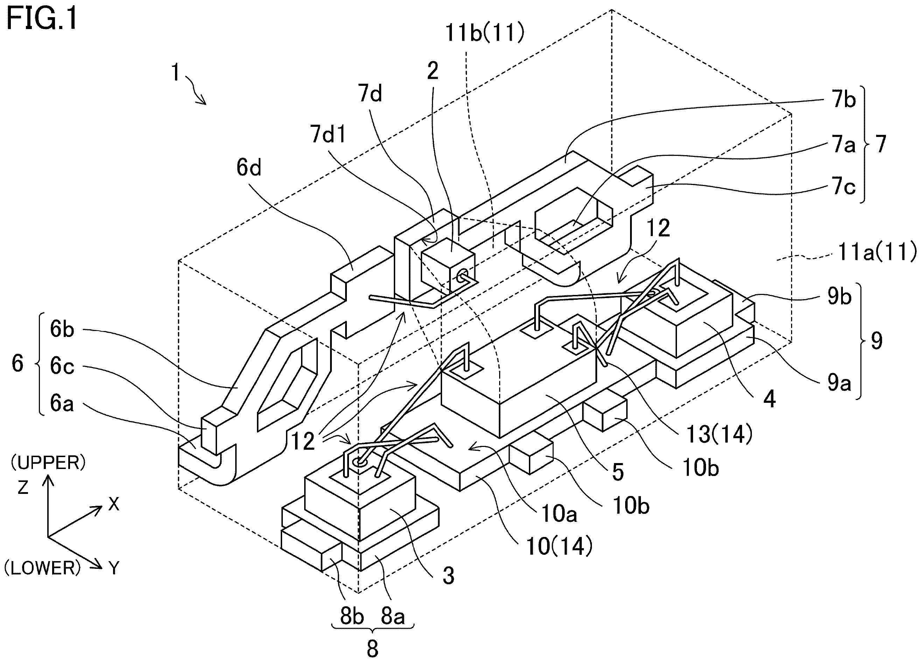

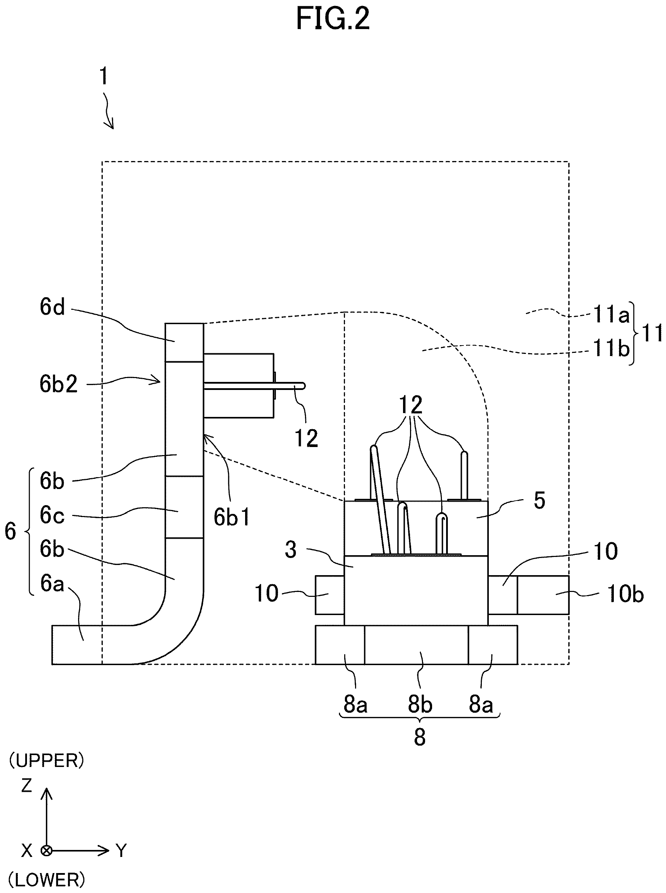

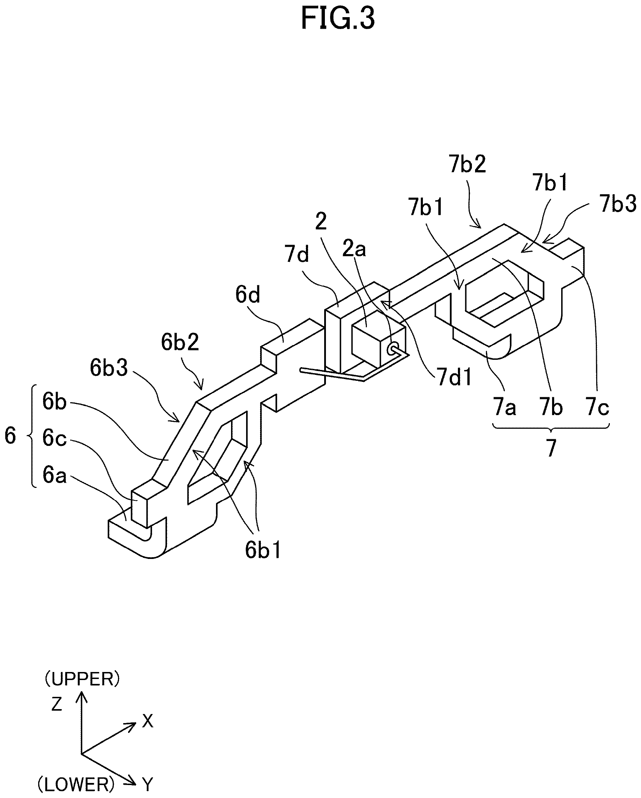

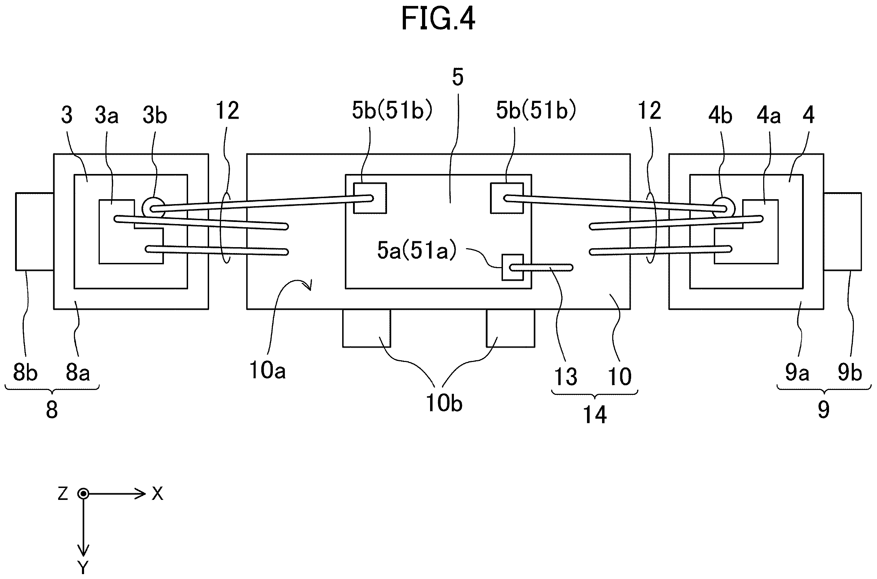

FIG. 1 shows a perspective view of a semiconductor relay according to a first embodiment, and FIG. 2 shows a view of the semiconductor relay along a second axis. FIG. 3 shows a perspective view of a first input terminal and a second input terminal on which a light emitting element is mounted, and FIG. 4 shows a view of a light receiving drive element, a first MOSFET, and a second MOSFET along a first axis. Note that for the sake of convenience in description, in FIGS. 1 and 2 and subsequent drawings, the outlines of a housing 11 and light blocking resin and translucent resin forming the housing 11 are indicated by dashed lines.

Note that in the following description, the direction of array of a first input terminal 6 and a second input terminal 7 may be referred to as an X-direction. Moreover, a virtual axis extending in the X-direction may be referred to as a second axis. The X-direction (second axis direction) is also the direction of array of a first output terminal 8 and a second output terminal 9. The direction of array of the first input terminal 6 and the first output terminal 8 may be referred to as a Y-direction. Moreover, a virtual axis extending in the Y-direction may be referred to as a third axis. The Y-direction (third axis direction) is also the direction of array of the second input terminal 7 and the second output terminal 9. The Y-direction is also the direction of array of a light emitting element 2 and a light receiving drive element 5.

A direction crossing the X-direction and the Y-direction may be referred to as a Z-direction. Moreover, a virtual axis extending in the Z-direction may be referred to as a first axis. The X-direction, the Y-direction, and the Z-direction are perpendicular to each other. Note that in the present specification, "perpendicular" means that components are perpendicular to each other, including the machining tolerance or manufacturing tolerance of each component forming a semiconductor relay 1 or the assembly tolerance of components, and does not mean that comparison targets are precisely perpendicular to each other.

In the Z-direction (first axis direction), the side on which the light emitting element 2 is disposed may be referred to as upper or above, and the side on which the light receiving drive element 5 is disposed may be referred to as lower or below. Note that the terms "upper" and "lower" in the present specification are merely relative terms and do not mean, for example, "upper" and "lower" in the vertical direction.

As shown in FIG. 1, the semiconductor relay 1 includes the light emitting element 2, the light receiving drive element 5, a first MOSFET 3, and a second MOSFET 4. Further, the semiconductor relay 1 includes the first input terminal 6, the second input terminal 7, the first output terminal 8, the second output terminal 9, a second base 10, and the housing 11.

### [1-2: Configurations of Light Emitting Element, Light Receiving Drive Element, And Second Base]

The light emitting element 2 is a publicly-known light emitting diode (LED). As shown in FIGS. 1 to 3, a cathode element (not shown) of the light emitting element 2 is connected and fixed to a first base 7d through a conductive adhesive (not shown) such as silver paste. The first base 7d is connected to the second input terminal 7.

An anode electrode 2a of the light emitting element 2 is electrically connected to a third base 6d through a wire 12. The third base 6d is connected to the first input terminal 6. The first input terminal 6 and the second input terminal 7 and the first base 7d and the third base 6d will be described later in detail.

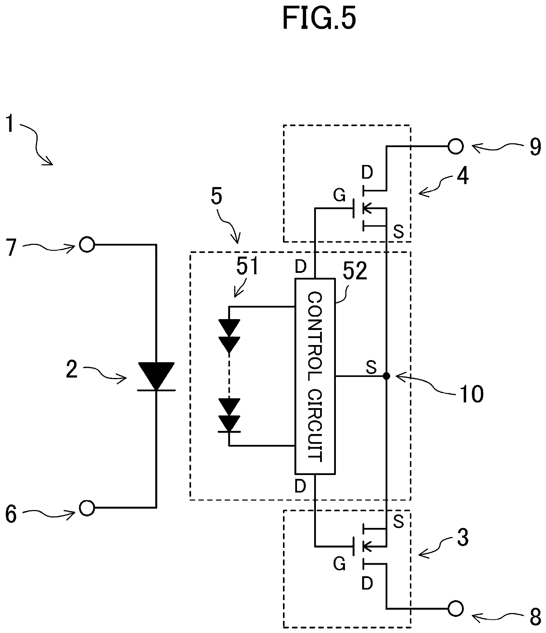

The light receiving drive element 5 has a light receiving element 51 and a control circuit 52 (see FIG. 5 for both). The light receiving element 51 receives light output from the light emitting element 2, and for example, is configured such that publicly-known photodiodes are arranged in array. As shown in FIGS. 1 to 3, a source electrode 5a and a drain electrode 5b are formed on the upper surface (first surface) of the light receiving drive element 5. The drain electrode 5b includes two drain electrodes 5b at locations apart from each other on the upper surface. Note that a light receiving portion of the light receiving element 51 as a portion for receiving the output light is also formed on the upper surface of the light receiving drive element 5, but is not shown in the figure for the sake of convenience in description.

Note that the source electrode 5a is equivalent to a cathode electrode 51a (hereinafter may be referred to as a first electrode 5a or a first electrode 51a) of the light receiving element 51, and the drain electrode 5b is equivalent to an anode electrode 51b of the light receiving element 51.

The lower surface (second surface) of the light receiving drive element 5 is connected and fixed to the second base 10 through a not-shown adhesive. The second base 10 is a quadrangular conductor as viewed along the first axis. Moreover, the surface of the second base 10 on which the light receiving drive element 5 is mounted will be referred to as a second principal surface 10a. The normal to the second principal surface 10a is parallel with the first axis, i.e., along the Z-direction. However, this does not mean that the normal is precisely parallel with the first axis.

The second base 10 has a portion (hereinafter referred to as a first outer exposed portion 10b) protruding from a side surface located on the side opposite to the first input terminal 6 and the second input terminal 7 among two side surfaces facing each other in the Y-direction and exposed to the outside from the side surface of the housing 11. The first outer exposed portion 10b includes two first outer exposed portions 10b at locations apart from each other along the second axis at the above-described side surface of the second base 10. Note that the location of the first outer exposed portion 10b and the number of first outer exposed portions 10b are not particularly limited to above.

As shown in FIGS. 1 to 3, the source electrode 5a of the light receiving drive element 5, i.e., the cathode electrode 51a (first electrode 51a) of the light receiving element 51, is electrically connected to the second base 10 through a wire 13. That is, the cathode electrode 51a of the light receiving element 51 has the same potential as that of the second base 10. One of the two drain electrodes 5b, 5b of the light receiving drive element 5 is electrically connected to a first gate electrode 3b of the first MOSFET 3 through a wire 12, and the other drain electrode 5b is electrically connected to a second gate electrode 4b of the second MOSFET 4 through a wire 12.

### [1-3: Configurations of First MOSFET and Second MOSFET]

As shown in FIGS. 1, 2, and 4, the first MOSFET 3 is a publicly-known vertical MOSFET, and has the first gate electrode 3b and a first source electrode 3a (hereinafter may be referred to as a first intermediate electrode 3a) on the upper surface and a first drain electrode (not shown) on the lower surface. The first drain electrode (hereinafter may be referred to as a first output electrode) of the first MOSFET 3 is electrically connected to the first output terminal 8, specifically to a fourth base 8a, through a conductive adhesive (not shown) such as silver paste.

The first source electrode 3a of the first MOSFET 3 is electrically connected to the second base 10 through a wire 12. That is, the first source electrode 3a of the first MOSFET 3 is electrically connected to the source electrode 5a of the light receiving drive element 5 through the second base 10 and the wire 12. Note that in the example shown in FIGS. 1 and 3, in order to strengthen connection, the first source electrode 3a of the first MOSFET 3 and the second base 10 are connected to each other through two wires 12, 12.

The second MOSFET 4 is a publicly-known vertical MOSFET, and has the second gate electrode 4b and a second source electrode 4a (hereinafter may be referred to as a second intermediate electrode 4a) on the upper surface and a second drain electrode (not shown) on the lower surface. The second drain electrode (hereinafter may be referred to as a second output electrode) of the second MOSFET 4 is electrically connected to the second output terminal 9, specifically a fifth base 9a, through a conductive adhesive (not shown) such as silver paste. The first output terminal 8 and the second output terminal 9 will be described later in detail.

The second source electrode 4a of the second MOSFET 4 is electrically connected to the second base 10 through a wire 12. That is, the second source electrode 4a of the second MOSFET 4 is electrically connected to the source electrode 5a of the light receiving drive element 5 through the second base 10 and the wire 12. Note that in the example shown in FIGS. 1 and 3, in order to strengthen connection, the second source electrode 4a of the second MOSFET 4 and the second base 10 are connected to each other through two wires 12, 12.

### [1-4: Configurations of First Input Terminal and Second Input Terminal]

As shown in FIGS. 1 and 3, the first input terminal 6 is a conductive member having a first standing portion 6b and a first outer connection portion 6a. Moreover, the first input terminal 6 is formed integrally with the third base 6d. The third base 6d, the first standing portion 6b, and the first outer connection portion 6a are obtained, for example, in such a manner that a single copper plate is punched or bent. Note that the method for manufacturing the first input terminal 6 is not particularly limited to above. The surface of the copper plate is plated with another metal film such as a metal film (not shown) containing nickel. Note that the material of the metal film is not particularly limited to above.

The third base 6d is a plate-shaped conductor located inside the housing 11 and having a quadrangular shape as viewed along the third axis. The wire 12 connected to the anode electrode 2a of the light emitting element 2 is connected to the third base 6d. Further, the first standing portion 6b is connected to a side surface on the side opposite to the second input terminal 7 among two side surfaces of the third base 6d facing each other in the X-direction. The normal to the surface of the third base 6d connected to the wire 12 is parallel with the third axis, i.e., along the Y-direction. However, this does not mean that the normal is precisely parallel with the third axis.

The first standing portion 6b has one end connected to the first outer connection portion 6a and extending from the first outer connection portion 6a along the first axis and the other end connected to the third base 6d. Moreover, the first standing portion 6b is provided so as to extend perpendicular to the lower surface of the housing 11 along the first axis. The surfaces of the first standing portion 6b, the normal to which is parallel with the third axis, may be referred to as principal surfaces 6b1, 6b2. The first standing portion 6b is a plate-shaped portion whose thickness direction is along the third axis. Thus, the first standing portion 6b has two principal surfaces 6b1, 6b2, and one principal surface 6b1 is at a location close to the second base 10 and the other principal surface 6b2 is at a location close to the side surface of the housing 11.

The normal to the principal surfaces 6b1, 6b2 of the first standing portion 6b are along the third axis.

The first standing portion 6b has an annular portion 6b3 as viewed along the third axis. Moreover, in the middle of the first standing portion 6b, a portion (hereinafter referred to as a fourth outer exposed portion 6c) protruding along the second axis and exposed to the outside from the side surface of the housing 11 is provided.

The first outer connection portion 6a extends downward from one end of the first standing portion 6b, is bent in the Y-direction in the vicinity of the lower surface of the housing 11, and is exposed from the side and lower surfaces of the housing 11.

The second input terminal 7 is a conductive member having a second standing portion 7b and a second outer connection portion 7a. Moreover, the second input terminal 7 is formed integrally with the first base 7d. The materials of the first base 7d and the second input terminal 7 and the methods for manufacturing the first base 7d and the second input terminal 7 are similar to those of the third base 6d and the first input terminal 6, and therefore, description thereof will be omitted. Moreover, the shapes of the first base 7d, the second standing portion 7b, and the second outer connection portion 7a and a connection relationship thereamong are similar to those of the third base 6d, the first standing portion 6b, and the first outer connection portion 6a, and therefore, detailed description thereof will be omitted. Further, the second standing portion 7b has a pair of principal surfaces 7b1, 7b2 as in the first standing portion 6b.

Note that in the middle of the second standing portion 7b, a portion (hereinafter referred to as a fifth outer exposed portion 7c) protruding along the first axis and exposed to the outside from the side surface of the housing 11 is provided, and the fifth outer exposed portion 7c is at a location facing the fourth outer exposed portion 6c in the X-direction. Note that in description below, the first standing portion 6b and the second standing portion 7b may be collectively referred to as a standing portion(s). Moreover, the first outer connection portion 6a and the second outer connection portion 7a may be collectively referred to as an outer connection portion(s).

The first base 7d is a plate-shaped conductor located inside the housing 11 and having a quadrangular shape as viewed along the third axis. Moreover, the surface of the first base 7d on which the light emitting element 2 is mounted will be referred to as a first principal surface 7d1. The normal to the first principal surface 7d1 is parallel with the third axis, i.e., along the Y-direction. Note that this does not mean that the normal is precisely parallel with the third axis.

The light emitting element 2 is connected and fixed to the first principal surface 7d1 of the first base 7d. Further, the second standing portion 7b is connected to a side surface on the side opposite to the first input terminal 6 among two side surfaces of the first base 7d facing each other in the X-direction. Moreover, the normal to the first principal surface 7d1 of the first base 7d is parallel with the third axis, i.e., along the Y-direction. Note that this does not mean that the normal is precisely parallel with the third axis.

### [1-5: Configurations of First Output Terminal and Second Output Terminal]

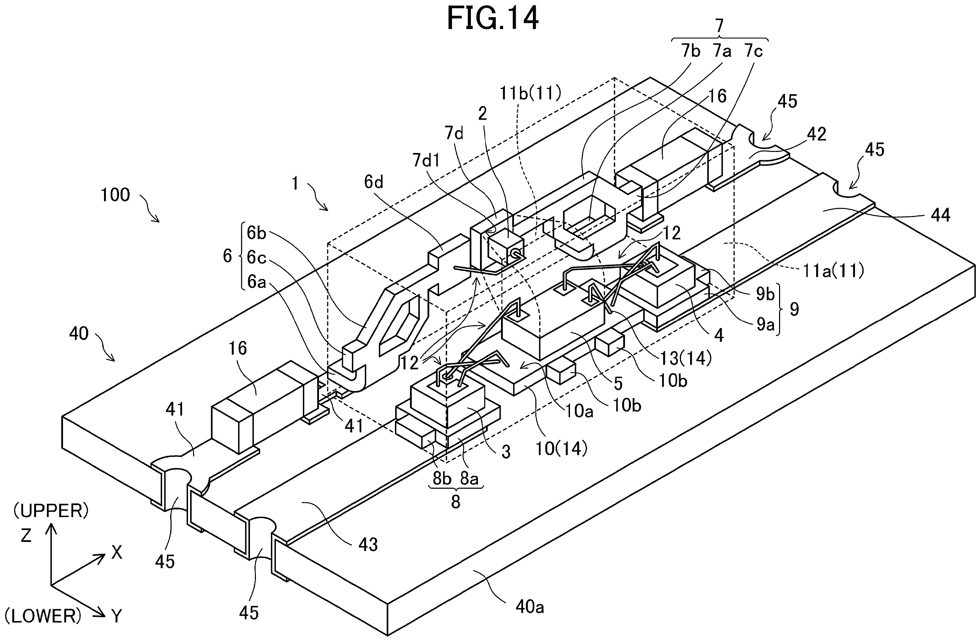

As shown in FIGS. 1, 3, and 4, the first output terminal 8 includes the fourth base 8a which is a quadrangular plate-shaped conductor as viewed along the first axis. Moreover, the lower surface of the fourth base 8a is exposed from the lower surface of the housing 11, and serves as a connection terminal for a later-described circuit board 40 (see FIGS. 14 to 16).

The fourth base 8a has a portion (hereinafter referred to as a second outer exposed portion 8b) protruding from a side surface on the side opposite to the second MOSFET 4 and the light receiving drive element 5 among two side surfaces facing each other in the X-direction and exposed to the outside from the side surface of the housing 11. Note that the number of second outer exposed portions 8b is not particularly limited to the number shown in FIGS. 1 and 3.

The second output terminal 9 includes the fifth base 9a which is a quadrangular plate-shaped conductor as viewed along the first axis. Moreover, the lower surface of the fifth base 9a is exposed from the lower surface of the housing 11, and serves as a connection terminal for the later-described circuit board 40 (see FIGS. 14 to 16).

The fifth base 9a has a portion (hereinafter referred to as a third outer exposed portion 9b) protruding from a side surface on the side opposite to the first MOSFET 3 and the light receiving drive element 5 among two side surfaces facing each other in the X-direction and exposed to the outside from the side surface of the housing 11. Note that the number of third outer exposed portions 9b is not particularly limited to the number shown in FIGS. 1 and 3.

### [1-6: Configuration of Housing]

As shown in FIGS. 1 and 2, the housing 11 has an upper surface, a lower surface, and four side surfaces. The lower surface is located below the upper surface in the first axis. Each of the four side surfaces is continuous to the upper and lower surfaces, and is parallel with the first axis. The normal to two side surfaces facing each other in the X-direction crosses the second axis, and the normal to two side surfaces facing each other in the Y-direction crosses the third axis.

The housing 11 has a light blocking portion 11a and a translucent portion 11b. The light blocking portion 11a is made, for example, of insulating epoxy resin containing a black pigment. Note that the light blocking portion 11a is not limited to above and is only required to be made of an insulating material blocking light. The translucent portion 11b is provided between the light receiving drive element 5 and the light emitting element 2, and is sealed with the light blocking portion 11a. Specifically, the translucent portion 11b covers, including the light emitting element 2, the first principal surface 7d1 of the first base 7d, extends along the third axis, is further bent downward, and covers the upper surface of the light receiving drive element 5.

The translucent portion 11b is made, for example, of insulating transparent silicone resin. Note that the translucent portion 11b is not limited to above and is only required to be made of an insulating material transparent to at least light emitted from the light emitting element 2. The translucent portion 11b forms an optical coupling portion that optically couples the light receiving element 51 (see FIG. 5) of the light receiving drive element 5 and the light emitting element 2 to each other.

The housing 11 seals the first input terminal 6, the second input terminal 7, the first to third bases 7d, 10, 6d, the first output terminal 8, and the second output terminal 9, and fixes the location of each of these components. Moreover, the location of the light emitting element 2 mounted on the first base 7d, the location of the first MOSFET 3 mounted on the fourth base 8a, the location of the second MOSFET 4 mounted on the fifth base 9a, and the location of the light receiving drive element 5 mounted on the second base 10 are fixed by the housing 11.

By the housing 11, the first input terminal 6 and the second input terminal 7 are electrically insulated from each other, and the first output terminal 8 and the second output terminal 9 are electrically insulated from each other. Further, by the housing 11, the light emitting element 2 and the light receiving drive element 5 are electrically insulated from each other, and the first MOSFET 3 and the second MOSFET 4 are electrically insulated from each other. That is, the semiconductor relay 1 described in the present specification is an input-output insulating semiconductor relay 1 that turns on and off an output signal with an input signal and an output signal electrically insulated from each other.

### [1-7: Relationship among First to Fifth Bases]

As described above, the normal to the first principal surface 7d1 of the first base 7d is along the third axis. On the other hand, the normal to the second principal surface 10a of the second base 10 is along the first axis. That is, the normal to the first principal surface 7d1 of the first base 7d is perpendicular to the normal to the second principal surface 10a of the second base 10. Note that these two normals are not necessarily perpendicular to each other. These normals may be shifted from each other within a predetermined crossing angle range from 90 degrees. The first base 7d is disposed with a gap from the second base 10 in the Y-direction as viewed along the first axis. Moreover, the first base 7d is located above the second base 10 in the first axis.

As viewed along the first axis, the third base 6d is disposed parallel with the first base 7d. That is, the third base 6d and the first base 7d are arranged with a gap therebetween in the X-direction, and are arranged at locations apart from the second base 10 as viewed along the first axis. Specifically, the third base 6d and the first base 7d are arranged symmetrically with the same distance from the second base 10.

The second base 10 is electrically connected to the source electrode 5a of the light receiving drive element 5 through the wire 13. That is, the second base 10 is connected so as to have the same potential as that of the source electrode 5a of the light receiving drive element 5. In the following description, the second base 10 and the wire 13 connecting the source electrode 5a (cathode electrode 51a of the light receiving element 51) of the light receiving drive element 5 and the second base 10 to each other may be referred to as a connection conductor 14.

The second base 10 is electrically connected to the first source electrode 3a (first intermediate electrode 3a) of the first MOSFET 3 through the wire 12. Further, the second base 10 is electrically connected to the second source electrode 4a (second intermediate electrode 4a) of the second MOSFET 4 through the wire 12. That is, the source electrode 5a of the light receiving drive element 5 is connected so as to have the same potential as those of the source electrodes 3a, 4a of the first MOSFET 3 and the second MOSFET 4.

As viewed along the first axis, the second base 10 is disposed between the fourth base 8a and the fifth base 9a with a gap from the fourth base 8a and the fifth base 9a. In other words, as viewed along the first axis, the second base 10 is disposed between the first MOSFET 3 and the second MOSFET 4. Further, as viewed along the first axis, the second base 10 is arranged between the first source electrode 3a of the first MOSFET 3 and the second source electrode 4a of the second MOSFET 4. Note that in the example shown in FIGS. 1 and 2, the second base 10 is located higher than the fourth base 8a and the fifth base 9a in the first axis with reference to the lower surface of the housing 11. That is, the lower surface of the second base 10 is covered with the light blocking portion 11a of the housing 11.

### [2: Operation of Semiconductor Relay]

FIG. 5 shows an equivalent circuit diagram of the semiconductor relay.

When an input signal is input between the first input terminal 6 and the second input terminal 7, the light emitting element 2 outputs light with a predetermined wavelength. The light emitted from the light emitting element 2 propagates in the translucent portion 11b, and is received by the light receiving element 51.

In the light receiving element 51, current is generated by photoelectric conversion, and the control circuit 52 operates with such current. A drive signal which is a voltage signal corresponding to the amount of light from the light emitting element 2 is applied to the first gate electrode 3b of the first MOSFET 3 and the second gate electrode 4b of the second MOSFET 4 through the wires 12.

When the voltage of the drive signal exceeds the threshold voltages of the first MOSFET 3 and the second MOSFET 4, a portion between the source (S) and drain (D) of the first MOSFET 3 and a portion between the source (S) and drain (D) of the second MOSFET 4 are turned on. Further, the first output terminal 8 and the second output terminal 9 come into conduction with each other through the first MOSFET 3 and the second MOSFET 4. This allows bidirectional transmission of a high frequency signal between the first output terminal 8 and the second output terminal 9.

When the input signal is not longer input between the first input terminal 6 and the second input terminal 7, light emission from the light emitting element 2 also stops. Accordingly, the current is no longer generated in the light receiving element 51, and the control circuit 52 stops.

As a result, the voltage of the drive signal applied to the first gate electrode 3b of the first MOSFET 3 and the second gate electrode 4b of the second MOSFET 4 decreases. When the voltage of the drive signal falls below the above-described threshold voltages, the portion between the source (S) and drain (D) of the first MOSFET 3 and the portion between the source (S) and drain (D) of the second MOSFET 4 are turned off. Further, the first output terminal 8 and the second output terminal 9 are disconnected from each other. Accordingly, signal transmission is blocked between the first output terminal 8 and the second output terminal 9.

### [3: Effects etc.]

As described above, the semiconductor relay 1 according to the present embodiment includes at least the housing 11, the first input terminal 6, the second input terminal 7, the first output terminal 8, and the second output terminal 9. Further, the semiconductor relay 1 includes the light emitting element 2, the light receiving drive element 5, the first MOSFET 3, and the second MOSFET 4.

The housing 11 has the upper surface and the lower surface located below the upper surface in the first axis.

The light emitting element 2 is electrically connected to the first input terminal 6 and the second input terminal 7.

The light receiving drive element 5 has the light receiving portion formed on the upper surface (first surface) of the light receiving drive element 5 as the portion for receiving light output from the light emitting element 2 and the source electrode 5a (first electrode 5a) provided in the vicinity of the light receiving portion. Further, the light receiving drive element 5 has the drain electrode 5b.

The first MOSFET 3 has the first source electrode 3a (first intermediate electrode 3a) electrically connected to the source electrode 5a of the light receiving drive element 5, the first drain electrode (first output electrode) electrically connected to the first output terminal 8, and the first gate electrode 3b.

The second MOSFET 4 has the second source electrode 4a (second intermediate electrode 4a) electrically connected to the source electrode 5a of the light receiving drive element 5, the second drain electrode (second output electrode) electrically connected to the second output terminal 9, and the second gate electrode 4b.

The semiconductor relay 1 further has the first base 7d and the connection conductor 14. The first base 7d has the first principal surface 7d1 on which the light emitting element 2 is disposed. Moreover, the first base 7d is connected to the second input terminal 7. The connection conductor 14 includes the second base 10. The second base 10 has the second principal surface 10a on which the light receiving element 51 is disposed, and is electrically connected to the source electrode 5a so as to have the same potential as that of the source electrode 5a of the light receiving drive element 5.

Part of the second base 10, i.e., the second base 10, is disposed between the first MOSFET 3 and the second MOSFET 4 as viewed along the first axis. Further, as viewed along the first axis, the second base 10 is disposed between the first source electrode 3a of the first MOSFET 3 and the second source electrode 4a of the second MOSFET 4. From another point of view, the second base 10 is disposed between the fourth base 8a on which the first MOSFET 3 is mounted and the fifth base 9a on which the second MOSFET 4 is mounted, as viewed along the first axis. Note that the wire 13 connecting the source electrode 5a of the light receiving drive element 5 and the second base 10 to each other may be disposed between the fourth base 8a and the fifth base 9a as viewed along the first axis, needless to say.

The normal to the first principal surface 7d1 of the first base 7d crosses the normal to the second principal surface 10a of the second base 10.

With this configuration of the semiconductor relay 1, capacitive coupling and inductive coupling between the input and the output can be reduced, and an input-side electrical length can be shortened. Thus, degradation of output-side high frequency characteristics can be reduced. This will be further described.

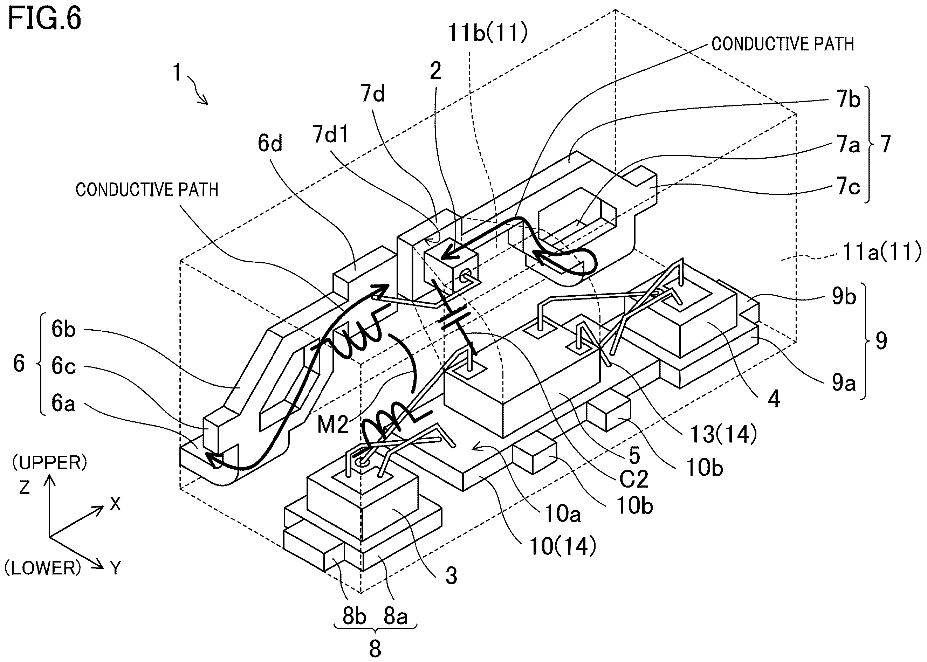

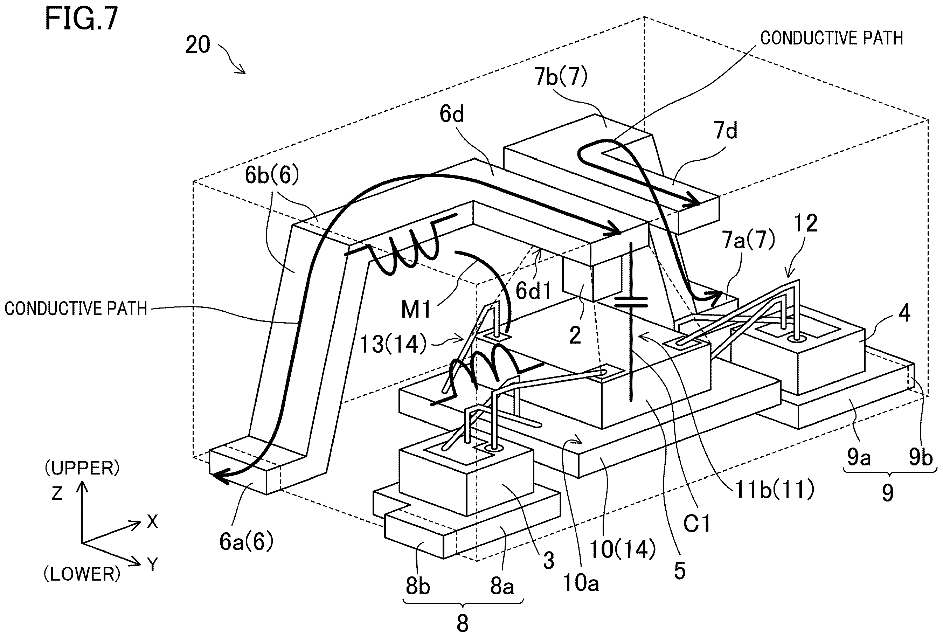

FIG. 6 shows a perspective view of the semiconductor relay according to the present embodiment, and FIG. 7 shows a perspective view of a semiconductor relay according to a comparative example. Note that FIGS. 6 and 7 show conductive paths to the light emitting element 2, parasitic capacitances, and parasitic mutual inductances. The parasitic capacitances C1, C2 and the parasitic mutual inductances M1, M2 shown in FIGS. 6 and 7 are shown as lumped constants for the sake of convenience. Moreover, the equivalent circuit diagram of the semiconductor relay according to the present embodiment can also be shown as distributed constants, e.g., between the first input terminal 6 and the first output terminal 8 and between the first input terminal 6 and the second base 10.

A semiconductor relay 20 shown in FIG. 7 is a comparative example showing a configuration similar to that disclosed in Patent Document 1, and is different from the semiconductor relay 1 of the present embodiment shown in FIG. 1 in the following points.

First, on the input side, the first base 7d is formed so as to extend from the upper end of the first input terminal 6 along the second axis. The third base 6d is formed so as to extend from the upper end of the second input terminal 7 along the second axis. As viewed along the first axis, the first base 7d and the third base 6d are provided so as to extend to above the light receiving drive element 5. The light emitting element 2 is connected and fixed to the lower surface of the third base 6d. Note that the anode electrode (not shown) of the light emitting element 2 and the first base 7d are connected to each other through the wire 12.

With these configurations, the light receiving element 51 is disposed immediately below the light emitting element 2 in the first axis in the semiconductor relay 20 shown in FIG. 7. Light output from the light emitting element 2 travels downward, and directly enters the light receiving element 51.

According to this configuration, the length of a stub can be shortened, and narrowing of an available frequency band due to the influence of the stub can be prevented. On the other hand, the first base 7d and the third base 6d are provided so as to extend to above the light receiving drive element 5, and therefore, an input-side conductive path, i.e., an input signal transmission path from the first input terminal 6 to the second input terminal 7 through the light emitting element 2 and the wire 12, is extended. Accordingly, the parasitic mutual inductance M2 due to inductive coupling of the first input terminal 6 to the second base 10 and the light receiving drive element 5 increases. Note that although not shown in FIG. 7, the parasitic mutual inductance due to inductive coupling of the second input terminal 7 to the second base 10 and the light receiving drive element 5 also increases because of a similar reason.

Moreover, as viewed along the first axis, the area of overlap between the third base 6d on which the light emitting element 2 is mounted and the second base 10 on which the light receiving drive element 5 is mounted increases. Accordingly, the parasitic capacitance C2 due to capacitive coupling of the first base 7d to the second base 10 and the light receiving drive element 5 increases.

In a case where the parasitic mutual inductance M2 and the parasitic capacitance C2 increase between the input and the output as described above, if a high frequency signal is transmitted between the first output terminal 8 and the second output terminal 9, the output-side high frequency signal may leak to the input side through the parasitic mutual inductance M2 and the parasitic capacitance C2.

In a case where the electrical length increases on the input side, a resonance frequency decreases, and a resonance phenomenon may occur. In this case, output-side signal transmission characteristics, i.e., the output-side high frequency characteristics, may be degraded.

On the other hand, according to the present embodiment, the first base 7d is provided continuously to the second standing portion 7b provided so as to extend along the first axis, as shown in FIGS. 1, 2, and 6. Moreover, the first principal surface 7d1 of the first base 7d is continuous to one principal surface 7b1 of the second standing portion 7b. That is, the normal to the first principal surface 7d1 of the first base 7d is along the third axis. On the other hand, the normal to the second principal surface 10a of the second base 10 is along the first axis, and these two normals cross each other. That is, the first principal surface 7d1 of the first base 7d and the second principal surface 10a of the second base 10 do not face each other in the first axis. With this configuration, the parasitic capacitance C1 due to capacitive coupling of the first base 7d to the second base 10 and the light receiving drive element 5 can be significantly decreased as compared to the above-described parasitic capacitance C2.

The first base 7d and the third base 6d can be reduced in size, and therefore, the input-side electrical length can be shortened as compared to the semiconductor relay 20 shown in FIG. 7. Thus, the parasitic mutual inductance M1 due to inductive coupling of the first input terminal 6 to the second base 10 and the light receiving drive element 5 can be decreased as compared to the above-described parasitic mutual inductance M2. Because of a similar reason, the parasitic mutual inductance due to inductive coupling of the second input terminal 7 to the second base 10 and the light receiving drive element 5 can also be decreased as compared to the semiconductor relay 20 shown in FIG. 7. Thus, the leakage of the output-side high frequency signal to the input side can be reduced, and degradation of the output-side high frequency characteristics can be reduced.

In a case where the electrical length increases due to the input side, the resonance frequency decreases, and the resonance phenomenon may occur. In this case, the output-side signal transmission characteristics, i.e., the output-side high frequency characteristics, may be degraded.

On the other hand, according to the present embodiment, the input-side electrical length can also be decreased as compared to the semiconductor relay 20 shown in FIG. 7. Thus, the input-side resonance frequency can be increased.

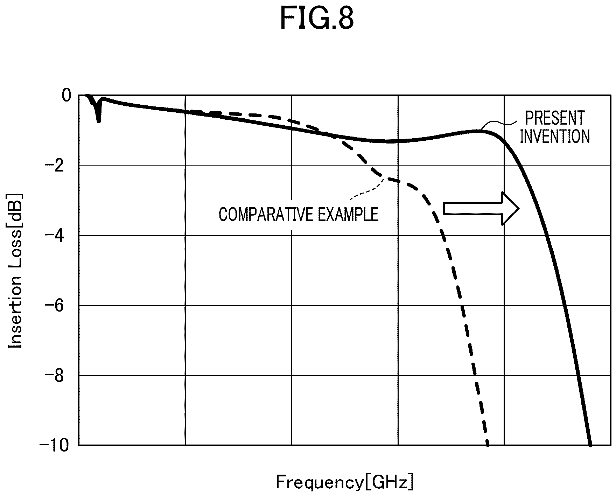

FIG. 8 shows one example of the frequency dependency of an insertion loss in the output-side transmission signal of the semiconductor relay.

As shown in FIG. 8, in a case where the semiconductor relay 1 of the present embodiment operates, a frequency at which the insertion loss starts increasing shifts to the high frequency side as compared to the semiconductor relay 20 of the comparative example shown in FIG. 7. That is, FIG. 8 shows that degradation of the high frequency characteristics on the output side of the semiconductor relay 1 is reduced.

Moreover, according to the present embodiment, at least part of the connection conductor 14 is disposed between the first MOSFET 3 and the second MOSFET 4 as viewed along the first axis. With this configuration, stub formation in a path from the first output terminal 8 to the second output terminal 9 through the first MOSFET 3, the second base 10, and the second MOSFET 4 can be reduced. Thus, narrowing of the frequency band of the output signal transmitted by the semiconductor relay 1 can be prevented.

The light emitting element 2 and the light receiving element 51 are arranged apart from each other as viewed along the first axis, and therefore, the light output from the light emitting element 2 can reliably enter the light receiving element 51 through the translucent portion 11b.

Note that the normal to the first principal surface 7d1 of the first base 7d is preferably perpendicular to the normal to the second principal surface 10a of the second base 10. With this configuration, capacitive coupling of the first base 7d to the second base 10 and the light receiving drive element 5 can be particularly decreased as compared to the comparative example.

Each of the first input terminal 6 and the second input terminal 7 has the outer connection portion and the standing portion. The outer connection portion is provided so as to extend along the lower surface of the housing 11, and has the tip end exposed to the outside of the housing 11. The standing portion is formed continuously to the base end of the outer connection portion so as to cross the lower surface of the housing 11 and extend in the housing 11 with the normal to the principal surface of the standing portion along the third axis. Moreover, the standing portion is provided such that the normal to the principal surface thereof is along the third axis, and therefore, a physical conductive path between the outer connection portion and the first base 7d can be shortened. That is, the input-side electrical length can be shortened.

The outer connection portion electrically connected to the outside is provided so as to extend along the lower surface of the housing 11, and therefore, the semiconductor relay 1 can be surface-mounted on a line provided on the upper surface of the circuit board 40 (see FIGS. 14 to 16), for example. Moreover, the standing portion is provided continuously to the outer connection portion so as to cross the lower surface of the housing 11, and therefore, the light emitting element 2 can be disposed on the side close to the upper surface of the housing 11. Thus, a distance between the light receiving element 51 located on the side close to the lower surface of the housing 11 and the light emitting element 2 can be ensured. Moreover, the light output from the light emitting element 2 can be guided to the light receiving element 51 through the translucent portion 11b.

The longitudinal direction of the outer connection portion and the longitudinal direction of the standing portion cross each other, and a coupling portion between the outer connection portion and the standing portion is located inside the housing 11. Thus, the first input terminal 6 and the second input terminal 7 are reliably held by the light blocking portion 11a of the housing 11.

The standing portion preferably has a portion exposed to the outside of the housing 11. Specifically, the first standing portion 6b preferably has the fourth outer exposed portion 6c in the middle, and the second standing portion 7b preferably has the fifth outer exposed portion 7c in the middle.

Normally, the first input terminal 6, the third base 6d, the second input terminal 7, and the first base 7d are obtained by machining of a single metal plate material. In manufacturing of a plurality of semiconductor relays 1, assembly of the light emitting element 2 after the first input terminal 6 and the second input terminal 7 have been separated into pieces is low in efficiency.

For this reason, a metal plate material is machined to form an input terminal base material including plural groups coupled to each other with the first input terminal 6, the third base 6d, the second input terminal 7, and the first base 7d as one group. In this state, the light emitting elements 2 are each connected and fixed to the first bases 7d, and the anode electrodes 2a of the light emitting elements 2 are each connected to the third bases 6d through the wires 12. Moreover, the translucent portion 11b made of the translucent resin is formed in each portion between the light emitting element 2 and the light receiving drive element 5.

A similar process is also performed on the output side. That is, a metal plate material is machined to form an output terminal base material including plural groups coupled to each other with the first output terminal 8, the second base 10, and the second input terminal 7 as one group. In this state, the light receiving drive elements 5, the first MOSFETs 3, and the second MOSFETs 4 are each connected and fixed to the second bases 10, the fourth bases 8a, and the fifth bases 9a. Further, the components are connected to each other through the wires 12, 13.

After such formation, the input terminal base material and the output terminal base material are arranged with aligned with each other, each element is sealed by resin injection, and in this manner, the housing 11 is formed. After formation of the housing 11, portions coupled to a metal frame are cut, and the plurality of semiconductor relays 1 are separated into pieces.

The fourth outer exposed portion 6c and the fifth outer exposed portion 7c are portions of the first input terminal 6 and the second input terminal 7 coupled to the metal frame. The first input terminal 6 and the second input terminal 7 are formed such that the fourth outer exposed portion 6c and the fifth outer exposed portion 7c remain, and therefore, assembly of the semiconductor relay 1 is facilitated. Moreover, a great amount of semiconductor relays 1 can be easily manufactured.

Because of a similar reason, the connection conductor 14, specifically the second base 10, preferably has the first outer exposed portions 10b as a portion exposed to the outside of the housing 11. Moreover, the fourth base 8a preferably has the second outer exposed portion 8b as a portion exposed to the outside of the housing 11, and the fifth base 9a preferably has the third outer exposed portion 9b as a portion exposed to the outside of the housing 11.

The connection conductor 14 preferably includes the second base 10 on which the light receiving element 51 is mounted, and the second base 10 is preferably arranged between the fourth base 8a on which the first MOSFET 3 is mounted and the fifth base 9a on which the second MOSFET 4 is mounted. Moreover, the second base 10 is more preferably disposed between the first source electrode 3a of the first MOSFET 3 and the second source electrode 4a of the second MOSFET 4.

With this configuration, the path from the first output terminal 8 to the second output terminal 9 through the first MOSFET 3, the second base 10, and the second MOSFET 4 can be linearly provided along the second axis, and stub formation can be reliably reduced. Thus, narrowing of the frequency band of the output signal transmitted by the semiconductor relay 1 can be reliably prevented.

Note that the first standing portion 6b and the second standing portion 7b each have the annular portions 6b3, 7b3 in the middle as viewed along the second axis. As shown in FIG. 3, the annular portions 6b3, 7b3 have through-holes penetrating the first standing portion 6b and the second standing portion 7b. With this configuration, the self-inductance and the parasitic mutual inductance due to inductive coupling can be reduced. Moreover, capacitive coupling between the second base 10 and the light receiving drive element 5 can be reduced. Further, as compared to a case where the widths of the first standing portion 6b and the second standing portion 7b are decreased, the mechanical strengths of the first input terminal 6 and the second input terminal 7 can be ensured.

### <First Modification>

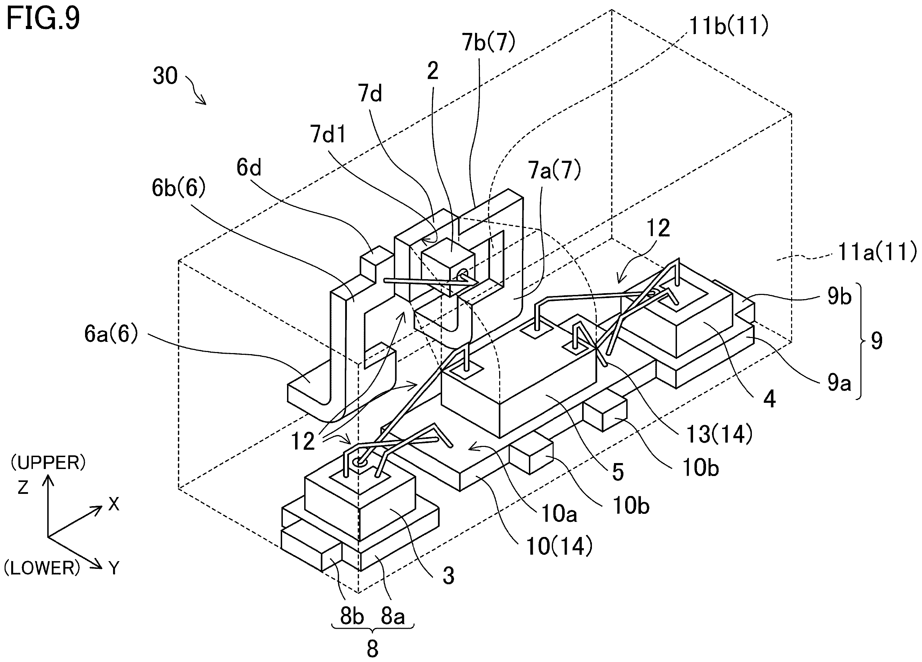

FIG. 9 shows a perspective view of a semiconductor relay according to a first modification. Note that for the sake of convenience in description, the same reference numerals are used to represent elements similar to those of the first embodiment in FIG. 9 and subsequent drawings and detailed description thereof will be omitted.

The semiconductor relay 30 of the present modification shown in FIG. 9 is different from the semiconductor relay 1 of the first embodiment shown in FIG. 1 in the following points.

First, as viewed along the first axis, the first outer connection portion 6a and the second outer connection portion 7a which are the outer connection portions of the first input terminal 6 and the second input terminal 7 are located between the first output terminal 8 and the second output terminal 9. Moreover, each of the first standing portion 6b and the second standing portion 7b is not in the annular shape but in an L-shape as viewed along the second axis.

The arrangement and shapes of the first input terminal 6 and the second input terminal 7 may be changed as described in the present modification. With this configuration, the conductive path from the first input terminal 6 to the light emitting element 2 and the conductive path from the light emitting element 2 to the second input terminal 7 can be shortened as compared to those in the semiconductor relay 1 described in the first embodiment. That is, the input-side electrical length can be shortened as compared to the semiconductor relay 1 described in the first embodiment.

Thus, the input-side resonance frequency can be increased, and occurrence of the resonance phenomenon can be reduced. Consequently, degradation of the output-side high frequency characteristics can be reduced.

Note that the lengths of the first standing portion 6b and the second standing portion 7b can be shortened as compared to the case described in the first embodiment, and therefore, the shapes of these portions are not necessarily in the annular shape described in the first embodiment for the purpose of reducing inductive coupling and capacitive coupling.

### <Second Modification>

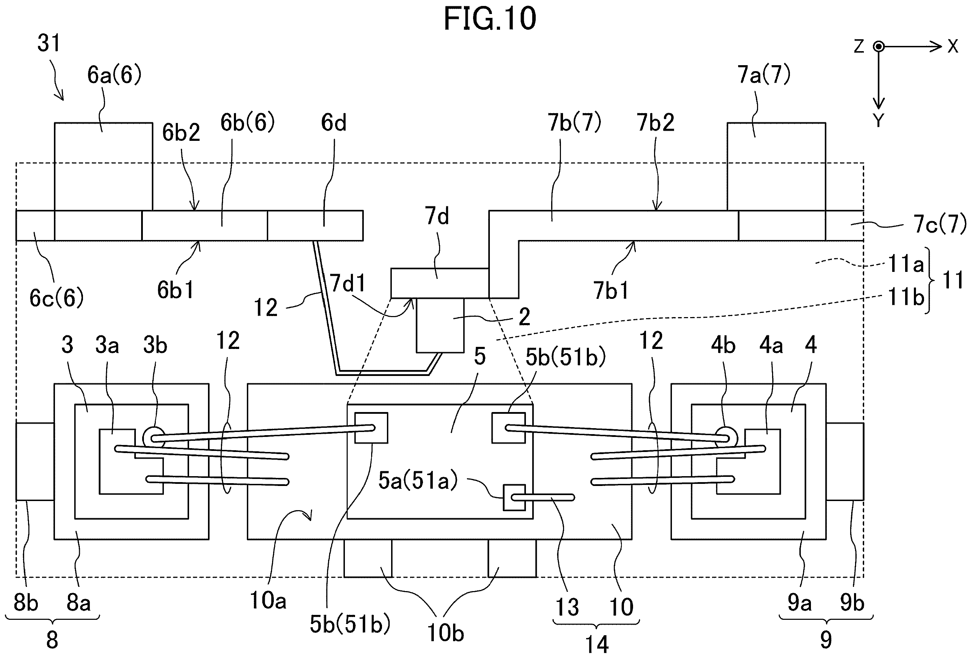

FIG. 10 is a view of a semiconductor relay according to a second modification along the first axis, and the semiconductor relay 31 of the present modification shown in FIG. 10 is different from the semiconductor relay 1 of the first embodiment shown in FIG. 1 in the following points.

That is, the second input terminal 7 is configured such that the tip end of the second standing portion 7b is bent so as to extend along the third axis. The first input terminal 6 and the second input terminal 7 are at locations shifted to the side opposite to the output side in the third axis as compared to the case described in the first embodiment. In other words, as viewed along the first axis, the first base 7d is located on the side closer to the second base 10 which is part of the connection conductor 14 than part of the first input terminal 6 and the second input terminal 7.

With this configuration, the optical coupling efficiency between the light emitting element 2 and the light receiving element 51 can be ensured similarly to the optical coupling efficiency of the first embodiment, and the parasitic capacitance component can be decreased and the high frequency characteristics can be improved as compared to the first embodiment. Thus, according to the light output from the light emitting element 2, the high frequency signal can be reliably transmitted and blocked between the first output terminal 8 and the second output terminal 9.

### <Third Modification>

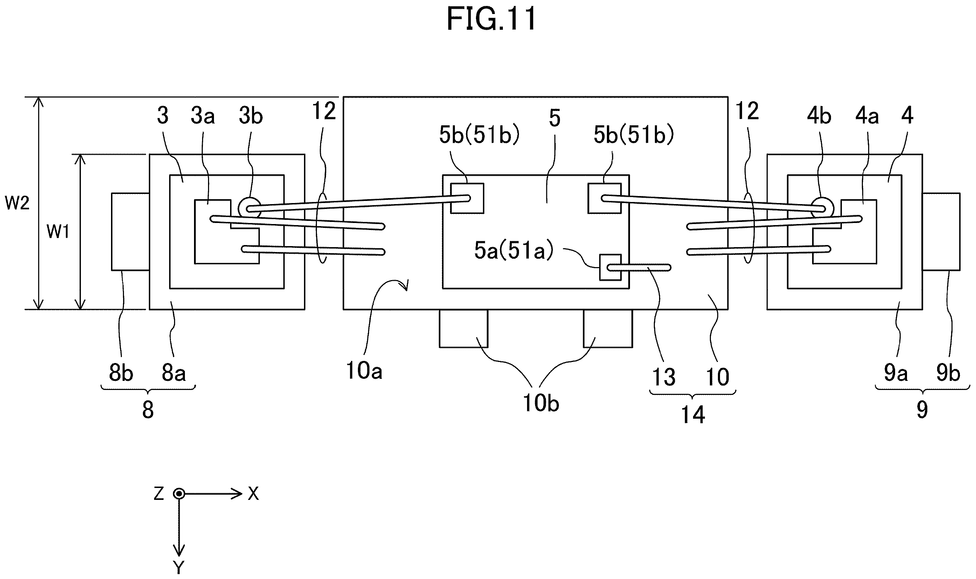

FIG. 11 is a view of a light receiving drive element, a first MOSFET, and a second MOSFET according to a third modification along the first axis.

The second base 10 shown in FIG. 11 is different from the second base 10 of the first embodiment shown in FIG. 3 in that the width W2 thereof along the third axis is greater than the width W1 of the first output terminal 8 and the second output terminal 9 along the third axis.

The width W2 of the second base 10 is set as described above so that an increase in a transmission line path characteristic impedance due to a portion of the second base 10 at a location higher than the bottom of the housing 11 can be suppressed, and the insertion loss can be reduced.

### (Second Embodiment)

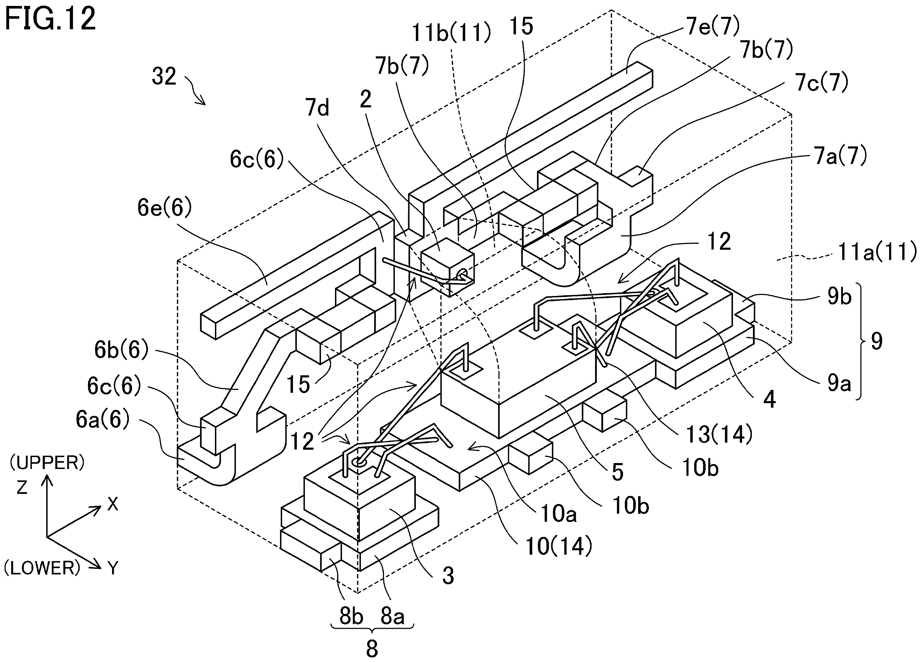

FIG. 12 shows a perspective view of a semiconductor relay according to a second embodiment.

The semiconductor relay 32 of the present embodiment shown in FIG. 12 is different from the semiconductor relay 1 of the first embodiment shown in FIG. 1 in that a chip resistor 15 which is an electronic component is inserted as a resistor element into each of an intermediate portion of the first input terminal 6 and an intermediate portion of the second input terminal 7.

Specifically, the first standing portion 6b of the first input terminal 6 is divided in the middle, and the chip resistor 15 is connected in series with the first standing portion 6b to connect the divided portions to each other. Similarly, the second standing portion 7b of the second input terminal 7 is divided in the middle, and the chip resistor 15 is connected in series with the second standing portion 7b to connect the divided portions to each other. The anode electrode 2a of the light emitting element 2 is electrically connected to the first standing portion 6b through the wire 12. A sixth outer exposed portion 6e is further provided, which linearly extends from the first standing portion 6b connected to the light emitting element 2 through the wire 12 along the second axis and reaches the side surface of the housing 11. In addition, a seventh outer exposed portion 7e is provided, which linearly extends from the first base 7d to the side opposite to the sixth outer exposed portion 6e along the second axis and reaches the side surface of the housing 11. The first to seventh outer exposed portions 10b, 8b, 9b, 6c, 7c, 6e, 7e will also be collectively referred to as an outer exposed portion(s).

Note that since the chip resistor 15 is connected in series with each of the first standing portion 6b and the second standing portion 7b, the first standing portion 6b and the second standing portion 7b are not in the annular shape. Moreover, the third base 6d connected to the first input terminal 6 is omitted. This is for preventing an increase in the size of the semiconductor relay 32 along the second axis due to insertion of the chip resistor 15. The third base 6d may be provided within such a range that the size increase is acceptable.

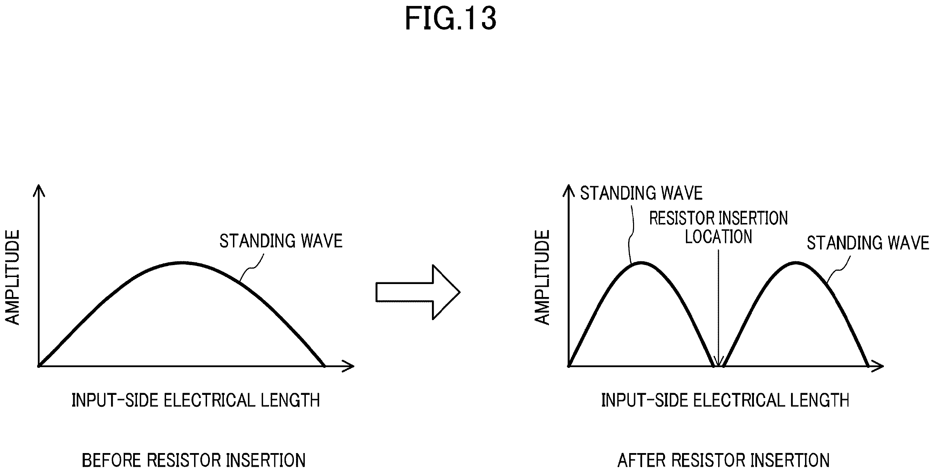

According to the present embodiment, the input-side electrical length can be reliably shortened as compared to the configuration described in the first embodiment. Thus, the input-side resonance frequency can be increased, and occurrence of the resonance phenomenon can be reduced. Consequently, degradation of the output-side high frequency characteristics can be reduced. Further description will be made using FIG. 13.

FIG. 13 is a schematic graph for describing a difference in the resonance phenomenon before and after insertion of the resistor into the input side.

In a case where the high frequency signal is input between the first input terminal 6 and the second input terminal 7, a standing wave is generated when the input-side electrical length reaches a predetermined value as shown on the left side in FIG. 13, and for this reason, the resonance phenomenon may occur. Thus, in order to increase the input-side resonance frequency, the wavelength of the standing wave needs to be shortened.

For this reason, as described in the present embodiment, the resistor element having a higher resistance value than that of the input-side conductive path is inserted and electrically connected in series in the middle of such a conductive path. With this configuration, the vibration of the standing wave is significantly attenuated at the location into which the resistor element is inserted. That is, the resistor element insertion location is the node of the standing wave. As a result, as shown on the right side in FIG. 13, the wavelength of the standing wave can be shortened, and the input-side resonance frequency can be increased. As a result, occurrence of the resonance phenomenon and degradation of the output-side high frequency characteristics can be reduced.

Note that as shown on the right side in FIG. 13, in order to shorten the wavelength of the standing wave, it is effective to insert the resistor element into the midpoint between the original nodes of the standing wave. That is, if the resonance phenomenon has occurred in the semiconductor relay 1 before insertion of the resistor element, the resistor element is inserted in series not in the vicinity of each end portion of the first input terminal 6 and the second input terminal 7, but preferably in each physically intermediate portion.

As shown in FIG. 12, the chip resistors 15 do not necessarily inserted as the resistor elements into both the first input terminal 6 and the second input terminal 7. The chip resistor 15 is only required to be connected in series in at least one of the conductive path connecting the first input terminal 6 and the light emitting element 2 to each other or the conductive path connecting the second input terminal 7 and the light emitting element 2 to each other.

Note that the resistance value of the chip resistor 15 is preferably higher than the resistance value of the above-described conductive path, but a specific value may be changed as necessary according to, e.g., the frequency of the input signal and the resistance value of the conductive path.

In order to shorten the input-side electrical length, a method other than insertion of the resistor element may be employed. For example, instead of the chip resistor 15, a chip inductor which is an inductor element having a higher impedance than that of the above-described conductive path in a high frequency domain may be provided to shorten the input-side electrical length. In this case, occurrence of the resonance phenomenon can also be reduced, and degradation of the output-side high frequency characteristics can also be reduced.

### (Third Embodiment)

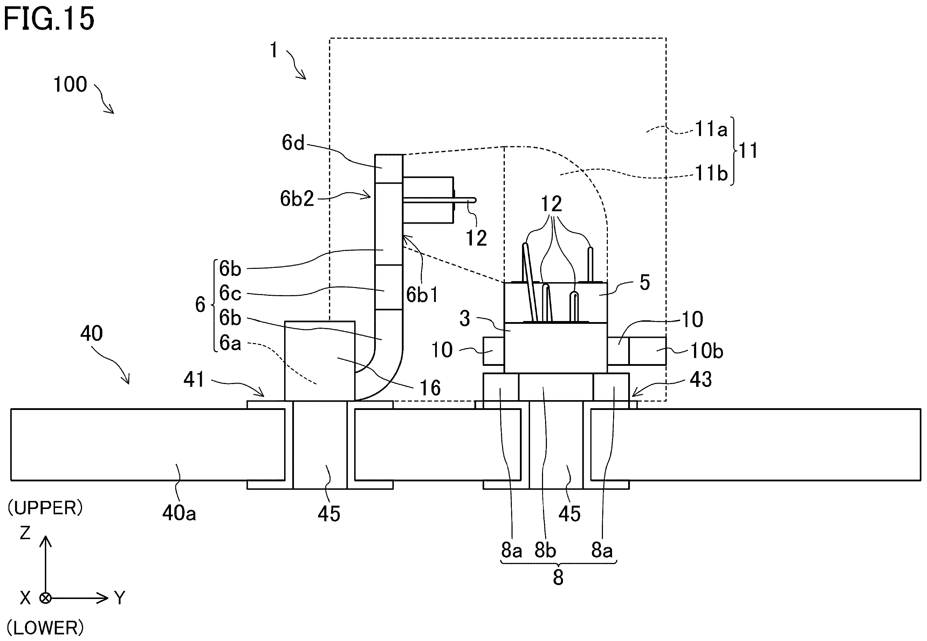

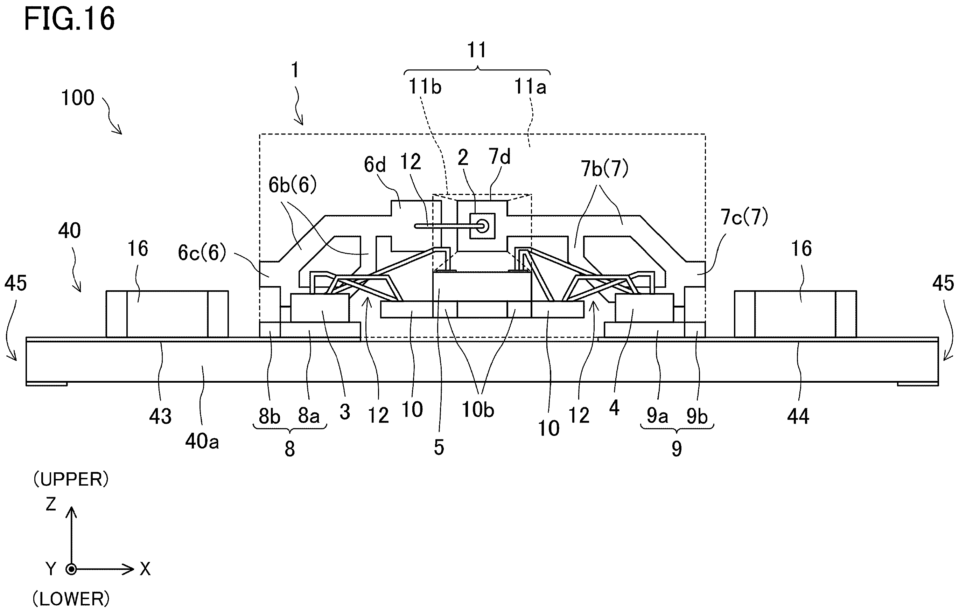

FIG. 14 shows a perspective view of a semiconductor relay module according to a third embodiment, FIG. 15 shows a view of the semiconductor relay module along the second axis, and FIG. 16 shows a view of the semiconductor relay module along the third axis.

As shown in FIGS. 14 to 16, the semiconductor relay module 100 includes at least a semiconductor relay 1 and a circuit board 40. The semiconductor relay 1 has a configuration similar to that described in the first embodiment, and therefore, detailed description thereof will be omitted.

The circuit board 40 is a so-called printed wiring board having first to fourth lines 41 to 44 on a dielectric board 40a made of a dielectric material having a predetermined specific inductive capacity.

The first to fourth lines 41 to 44 are formed in such a manner that the upper surface of the dielectric board 40a is plated with, e.g., copper. Moreover, a conductive via 45 is connected to one end of each of the first to fourth lines 41 to 44. The conductive via 45 is formed in such a manner that a via hole penetrating the dielectric board 40a in the thickness direction thereof is filled with a conductor using, e.g., copper plating. Note that in order to simplify a process of manufacturing the semiconductor relay module 100, this conductor is preferably formed at the same time as formation of the first to fourth lines 41 to 44.

Of the third line 43 and the fourth line 44, end portions (hereinafter referred to as other end) opposite to one ends to which the conductive vias 45 are connected are connected to the first output terminal 8 and second output terminal 9 of the semiconductor relay 1. For such connection, a conductive adhesive such as silver paste or solder cream is used.

At the other ends of the first line 41 and the second line 42, the first input terminal 6 and second input terminal 7 of the semiconductor relay 1 are connected. For such connection, a conductive adhesive such as silver paste or solder cream is used.

On the other hand, each of the first line 41 and the second line 42 is divided in the vicinity of the other end. In each of the first line 41 and the second line 42, a chip resistor 16 is connected as a resistor element in series to connect the divided portions to each other.

Input signals are transmitted from the conductive via 45 connected to the first line 41 and the conductive via 45 connected to the second line 42 to the first line 41 and the second line 42. Further, the input signals are transmitted to the first input terminal 6 and second input terminal 7 of the semiconductor relay 1. During a period for which an input signal with an amplitude of a predetermined value or more is input, a high frequency signal is transmitted between the third line 43 connected to the first output terminal 8 and the fourth line 44 connected to the second output terminal 9 through the semiconductor relay 1. Further, a high frequency signal is transmitted between the conductive via 45 connected to the third line 43 and the conductive via 45 connected to the fourth line 44. When the amplitude of the input signal reaches the predetermined value or less, high frequency signal transmission is blocked between the third line 43 and the fourth line 44 and between the conductive via 45 connected to the third line 43 and the conductive via 45 connected to the fourth line 44.

According to the present embodiment, in the semiconductor relay 1, capacitive coupling and inductive coupling between the input and the output can be reduced, and the input-side electrical length can be shortened. Thus, degradation of high frequency characteristics of an output signal transmitted between the third line 43 and the fourth line 44 can be reduced.

Moreover, in the semiconductor relay module 100 of the present embodiment, in each of the first line 41 and the second line 42 connected to the second input terminal 7, the chip resistor 16 is connected in series in the vicinity of the first input terminal 6 and the second input terminal 7. In the vicinity of a portion of the first line 41 connected to the first input terminal 6, the chip resistor 16 is inserted and electrically connected in series as a resistor element having a predetermined resistance value. Moreover, in the vicinity of a portion of the second line 42 connected to the second input terminal 7, the chip resistor 16 is inserted and electrically connected in series as a resistor element having a predetermined resistance value.

With this configuration, the wavelength of the standing wave can be shortened and the input-side resonance frequency can be increased, as described in the second embodiment with reference to FIG. 13. As a result, occurrence of the resonance phenomenon and degradation of the output-side high frequency characteristics can be reduced.

Note that one of the resistor element connected to the first line 41 or the resistor element connected to the second line 42 is not necessarily connected. In a case where the semiconductor relay 1 and the semiconductor relay module 100 are designed such that the input-side resonance frequency is a predetermined value or more, it is not essential to connect the chip resistor 16 as the resistor element, and the chip resistor 16 is not necessarily connected. In this case, the first line 41 and the second line 42 are not divided and are continuously provided from the conductive vias 45 to the first input terminal 6 and the second input terminal 7. Instead of the chip resistor 15, a chip inductor may be used.

Note that FIGS. 14 to 16 show the semiconductor relay module 100 configured such that only the semiconductor relay 1 is mounted on the circuit board 40, but other elements may be mounted on the circuit board 40. The conductive via 45 penetrating the circuit board 40 is not necessarily provided. A structure may be employed, in which a plurality of connection pad electrodes (not shown) for the outside are provided on the upper surface of the circuit board 40 and are each connected to the first to fourth lines 41 to 44.

### (Other Embodiments)

The components described in the first to third embodiments and the first to third modifications may be combined as necessary to form a new embodiment. For example, in the semiconductor relay module 100 described in the third embodiment, the configuration of the semiconductor relay 1 may be the configuration described in the second embodiment or the first to third modifications.

In the present specification, the first output terminal 8 and the second output terminal 9 have, as outer portions, the back surfaces of the fourth base 8a and the fifth base 9a exposed from the housing 11, such as the connection portions for the third line 43 and the fourth line 44 as shown in FIGS. 14 to 16, but are not particularly limited thereto. The semiconductor relay 1 is only required to be the surface mounting relay, and for example, outer connection portions extending along the lower surface of the housing 11 and exposed to the outside from the side surface of the housing 11 as in, e.g., the first input terminal 6 and the second input terminal 7 may be each provided in the first output terminal 8 and the second output terminal 9.

The first outer connection portion 6a of the first input terminal 6 and the second outer connection portion 7a of the second input terminal 7 do not necessarily protrude to the outside from the side surfaces of the housing 11. That is, the outer connection portion is only required to be exposed at least from the lower surface of the housing 11. With this configuration, the surface mounting semiconductor relay 1 can be provided.

The control circuit 52 may be formed on another semiconductor chip different from that for the light receiving element 51. In this case, the control circuit 52 is preferably sealed with the light blocking portion 11a of the housing 11.

### INDUSTRIAL APPLICABILITY

The semiconductor relay of the present disclosure is useful as a high frequency signal transmission relay capable of reducing degradation of output-side high frequency characteristics.

### DESCRIPTION OF REFERENCE CHARACTERS

- 1: Semiconductor Relay
- 2: Light Emitting Element
- 2a: Anode Electrode
- 3: First MOSFET
- 3a: First Source Electrode (First Intermediate Electrode)
- 3b: First Gate Electrode
- 4: Second MOSFET
- 4a: Second Source Electrode (Second Intermediate Electrode)
- 4b: Second Gate Electrode
- 5: Light Receiving Drive Element
- 5a: Source Electrode (First Electrode)
- 5b: Drain Electrode
- 6: First Input Terminal
- 6a: First Outer Connection Portion
- 6b: First Standing Portion
- 6c: Fourth Outer Exposed Portion
- 6d: Third Base
- 6e: Sixth Outer Exposed Portion
- 7: Second Input Terminal
- 7a: Second Outer Connection Portion
- 7b: Second Standing Portion
- 7c: Fifth Outer Exposed Portion
- 7d: First Base
- 7d1: First Principal Surface
- 7e: Seventh Outer Exposed Portion
- 8: First Output Terminal
- 8a: Fourth Base
- 8b: Second Outer Exposed Portion
- 9: Second Output Terminal
- 9a: Fifth Base
- 9b: Third Outer Exposed Portion
- 10: Second Base
- 10a: Second Principal Surface
- 10b: First Outer Exposed Portion
- 11: Housing
- 11a: Light Blocking Portion
- 11b: Translucent Portion
- 12: Wire
- 13: Wire
- 14: Connection Conductor
- 15: Chip Resistor (Resistor Element)
- 16: Chip Resistor (Resistor Element)
- 20: Semiconductor Relay
- 30 to 32: Semiconductor Relay
- 40: Circuit Board
- 40a: Dielectric Board
- 41 to 44: First to Fourth Lines
- 45: Conductive Via
- 51: Light Receiving Element
- 51a: Cathode Electrode (First Electrode)
- 51b: Anode Electrode
- 52: Control Circuit
- 100: Semiconductor Relay Module

## Claims

1. A semiconductor relay comprising at least:
a housing having an upper surface and a lower surface located below the upper surface in a first axis;
a first input terminal and a second input terminal;
a first output terminal and a second output terminal;
a light emitting element electrically connected to the first input terminal and the second input terminal;
a light receiving drive element having a first surface receiving light output from the light emitting element, a second surface located below the first surface in the first axis, and a first electrode;
a first MOSFET having a first intermediate electrode electrically connected to the first electrode, a first output electrode electrically connected to the first output terminal, and a first gate electrode;
a second MOSFET having a second intermediate electrode electrically connected to the first electrode, a second output electrode electrically connected to the second output terminal, and a second gate electrode;
a first base having a first principal surface on which the light emitting element is disposed; and
a connection conductor having a second principal surface on which the light receiving drive element is disposed and connected to the first electrode with a potential equal to that of the first electrode,
wherein at least part of the connection conductor is disposed between the first MOSFET and the second MOSFET as viewed along the first axis, and
a normal to the first principal surface crosses a normal to the second principal surface.

2. The semiconductor relay of claim 1, wherein
the light emitting element and the light receiving drive element are apart from each other as viewed along the first axis.

3. The semiconductor relay of claim 1, wherein
the normal to the first principal surface is perpendicular to the normal to the second principal surface.

4. The semiconductor relay of claim 1, wherein
each of the first input terminal and the second input terminal has an outer connection portion and a standing portion,
the outer connection portion is provided so as to extend along a lower surface of the housing, and has a tip end exposed to an outside of the housing,
the standing portion is formed continuously to a base end of the outer connection portion so as to cross the lower surface of the housing and extend in the housing, and
when an axis along a direction of array of the light emitting element and the light receiving drive element is a third axis, a normal to a principal surface of the standing portion is along the third axis.

5. The semiconductor relay of claim 4, wherein
the standing portion has an annular portion with a through-hole penetrating the standing portion.

6. The semiconductor relay of claim 4, wherein
the standing portion has a portion exposed to the outside of the housing.

7. The semiconductor relay of claim 1, wherein
the connection conductor has a portion exposed to an outside of the housing.

8. The semiconductor relay of claim 1, wherein
the connection conductor includes a second base on which the light receiving drive element is mounted, and
the second base has the second principal surface, and is disposed between a base on which the first MOSFET is mounted and a base on which the second MOSFET is mounted.

9. The semiconductor relay of claim 1, wherein
a resistor element having a predetermined resistance or an inductor element having a predetermined impedance is electrically connected in series in at least one of a conductive path connecting the first input terminal and the light emitting element to each other or a conductive path connecting the second input terminal and the light emitting element to each other.

10. The semiconductor relay of claim 8, wherein
when an axis along a direction of array of the light emitting element and the light receiving drive element is a third axis,
a width of the second base along the third axis is greater than a width of the first output terminal along the third axis or a width of the second output terminal along the third axis.

11. The semiconductor relay of claim 1, wherein
as viewed along the first axis, the first base is located on a side closer to the connection conductor than the first input terminal and the second output terminal.

12. The semiconductor relay of claim 4, wherein
as viewed along the first axis, the outer connection portion of each of the first input terminal and the second input terminal is located between the first output terminal and the second output terminal.

13. A semiconductor relay module comprising at least:
the semiconductor relay of claim 1; and
a circuit board on which first to fourth lines are formed,
wherein the first line and the second line are each connected to the first input terminal and the second input terminal of the semiconductor relay, and
the third line and the fourth line are each connected to the first output terminal and the second output terminal of the semiconductor relay.

14. The semiconductor relay module of claim 13, wherein
a resistor element having a predetermined resistance or an inductor element having a predetermined impedance is electrically connected in series in a vicinity of a portion of the first line connected to the first input terminal, and/or
a resistor element having a predetermined resistance or an inductor element having a predetermined impedance is electrically connected in series in a vicinity of a portion of the second line connected to the second input terminal.
